# FASCICULE DE BREVET EUROPEEN

(11) **EP 1 367 870 B1**
(45) Date de publication et mention de la délivrance du brevet: **18.01.2006**
(21) Numéro de dépôt: 03291196.8
(22) Date de dépôt: 20.05.2003
(51) Int. Cl.: H05K 1/02, H01L 33/00

(54) **Dispositif support de diode électroluminescente pour système de signalisation automobile, et procédé de fabrication d'un tel dispositif**
Halteeinrichtung für Leuchtdiode für Fahrzeugsignalsystem und Herstellungsverfahren
Holding device for light emitting diode for vehicle signaling system and method of making the same

(30) Priorité: 27.05.2002 FR 0206458
(43) Date de publication de la demande: 03.12.2003
(73) Titulaire: VALEO VISION, 93012 Bobigny Cédex (FR)
(72) Inventeur: Gasquet, Jean-Claude, 89100 Saint Clement (FR); Tanghe, Alcina, 77000 Melun (FR)
(74) Mandataire: Renous Chan, Véronique

(56) Documents cités:
- EP-A- 1 139 019
- WO-A-00/55685
- US-A1- 2001 030 866

## Description

L'invention est relative à un dispositif support de diode électroluminescente (led) pour système de signalisation ou d'éclairage automobile, comportant un support isolant, notamment en matière plastique, et des moyens de connexion aux électrodes de la diode électroluminescente.

On utilise déjà pour la signalisation des diodes électroluminescentes de faible puissance. Pour obtenir un flux lumineux suffisant, par exemple d'au moins 30 lumens, et réaliser une fonction de signalisation, on associe plusieurs diodes. La chaleur produite au sein de chaque diode de faible puissance est évacuée de manière satisfaisante par les électrodes assurant la connexion électrique. Une bonne dissipation thermique est en effet nécessaire car le rendement lumineux d'une diode électroluminescente diminue si sa température de jonction augmente.

Les progrès réalisés permettent d'obtenir maintenant des diodes électroluminescentes de puissance dont le flux lumineux dépasse 30 lumens. La chaleur dégagée par la diode de puissance est importante et ne peut être évacuée de manière satisfaisante par les électrodes. Une diode de puissance est ainsi généralement prévue avec une embase permettant d'établir un contact thermique efficace avec un moyen de dissipation de la chaleur.

Une seule diode électroluminescente de puissance pourrait assurer une fonction de signalisation automobile, par exemple feu de stop ou lanterne, mais son montage pose problème, notamment pour la dissipation thermique.

Dans l'industrie électronique des diodes électroluminescentes de puissance sont utilisées. Pour leur montage on emploie généralement un circuit connu sous le vocable " MCPCB " (Metal Core Printed Circuit Board) qui correspond à une solution issue de techniques utilisées dans l'électronique. Le circuit est rigide, et sert de support physique, de conducteur électrique et de dissipateur de chaleur.

Une telle solution est trop onéreuse pour le secteur automobile et ne peut convenir. En outre, sa compatibilité avec les techniques de signalisation automobile n'est pas satisfaisante.

Un dispositif support de diode électroluminescente est décrit dans le document US 2001/0030866.

L'invention a pour but, surtout, d'optimiser l'utilisation de diodes électroluminescentes de puissance pour réaliser des systèmes de signalisation ou d'éclairage automobile à un prix de revient suffisamment bas pour être acceptable. Une telle optimisation implique une extraction efficace de la chaleur produite par la diode afin d'optimiser les performances au niveau du flux lumineux utilisable.

Selon l'invention, un dispositif support de diode électroluminescente de puissance pour système de signalisation ou d'éclairage automobile, comporte un support isolant, notamment en matière plastique, et des moyens de connexion électrique aux électrodes de la diode; les moyens de connexion électrique comprennent, sur le support isolant, des pattes de raccordement électrique, le corps de la diode électroluminescente est fixé sur une zone d'un élément radiateur de chaleur, cet élément radiateur de chaleur est rapporté sur le support isolant, et les électrodes de la diode sont isolées de l'élément radiateur de chaleur et reliées électriquement aux pattes de raccordement du support isolant et est caractérisé par le fait que l'élément radiateur de chaleur comporte, sur son contour, au moins une échancrure en direction de la zone de fixation de la diode électroluminescente, au moins l'une des électrodes de la diode est disposée dans une échancrure correspondante de l'élément radiateur.

De préférence, les moyens de connexion électrique comprennent, dans l'échancrure ou dans chaque échancrure, une languette en matériau conducteur de l'électricité dont les bords sont distants de ceux l'échancrure et dont l'extrémité radiale extérieure se trouve au voisinage ou au-delà du contour extérieur de l'élément radiateur.

L'invention permet d'assurer, dans de bonnes conditions, une fonction de signalisation automobile, par exemple feu de stop ou lanterne, avec une seule diode électroluminescente de puissance.

L'invention exploite une synergie entre une technique purement électronique et une technique spécifique du secteur signalisation automobile. Il en résulte une optimisation des coûts, le maintien d' une compatibilité avec les méthodes utilisées pour des sources lumineuses classiques, et le maintien des qualités de base de dispositifs de signalisation déjà existants.

Le dispositif support selon l'invention constitue un terminal spécialisé pour diode électroluminescente de puissance, permettant de conserver la spécificité d'un terminal pour lampe classique. Le terminal forme une interface entre une carte électronique et la diode électroluminescente via un système de connectique.

La diode électroluminescente de puissance peut produire un flux lumineux d'au moins 30 lumens, en particulier d'au moins 40 lumens.

L'élément radiateur peut être obtenu à partir d'une feuille de métal bon conducteur de la chaleur et de l'électricité, en particulier une feuille de cuivre, d'épaisseur relativement faible, par exemple inférieure à 1mm. La rigidité, lorsque le dispositif est monté, est assurée par 1' assemblage au support isolant.

De préférence la zone de fixation de l'embase de la diode électroluminescente est constituée par la zone centrale de l'élément radiateur, lequel comportent deux échancrures opposées partant de son contour et dirigées vers la zone centrale ; chaque électrode de la diode est située respectivement dans une échancrure, et une languette conductrice électriquement se trouve dans chaque échancrure et est reliée à l'électrode correspondante, les bords de la languette étant distants de ceux de l'échancrure.

La languette est avantageusement constituée par une partie découpée de la feuille ou plaque formant radiateur, en correspondance avec une échancrure.

Dans un tel dispositif support, la fonction thermique d'évacuation de la chaleur par l'élément radiateur est séparée de la fonction conduction électrique assurée par les languettes disposées dans les échancrures et isolées électriquement du radiateur.

Le bord de la languette éloigné de la diode électroluminescente peut faire saillie au-delà du contour de l'élément radiateur pour faciliter une connexion électrique.

L'assemblage de l'élément radiateur et du support isolant peut être assuré par coopération de trous prévus dans l'élément radiateur et de picots, pions ou bouterolles prévus sur le support isolant.

Les électrodes de la diode peuvent être soudées par point, en particulier au laser.

L'invention est également relative à un procédé de fabrication d'un dispositif support tel que défini précédemment, ce procédé étant caractérisé par le fait que l'on prépare séparément un support isolant, notamment en matière plastique, muni de pattes de raccordement électrique, et un ensemble radiateur comportant une diode électroluminescente de puissance, et que l'on assemble mécaniquement le radiateur et le support isolant en assurant la liaison électrique des électrodes de la diode avec les pattes de raccordement.

Avantageusement, on réalise l'ensemble radiateur à partir d'une feuille ou d'une plaque de métal conducteur de la chaleur et de l'électricité, notamment du cuivre, dans laquelle on découpe partiellement, de part et d'autre d'une zone centrale, des languettes qui restent momentanément reliées par des attaches de section réduite, formant shunts, à la majeure partie de la feuille ou plaque pour assurer sa cohérence et son maintien mécanique; on met en place et on fixe, en particulier par collage, la diode électroluminescente sur la zone centrale de l'élément radiateur; on procède à la soudure de chaque électrode de la diode avec une languette respective et on brise ensuite les shunts de liaison entre languettes et élément radiateur de manière à assurer l'isolation électrique de chaque languette vis-à-vis de l'élément radiateur.

Les shunts de liaison entre une languette et l'élément radiateur ont une section suffisante pour assurer le maintien mécanique, mais relativement faible pour limiter l'évacuation de chaleur par les shunts lors de la soudure des électrodes sur les languettes.

Avec ses deux échancrures opposées l'élément radiateur a sensiblement une forme de H à larges branches.

L'invention consiste, mises à part les dispositions exposées ci-dessus, en un certain nombre d'autres dispositions dont il sera plus explicitement question ci-après à propos d'exemples de réalisation décrits en détail avec référence aux dessins annexés, mais qui ne sont nullement limitatifs.

Sur ces dessins :
Fig.1 est une vue schématique en perspective d'un support isolant en matière plastique pour dispositif selon l'invention.
Fig.2 est une vue en perspective d'une diode électroluminescente de puissance installée sur un élément radiateur, alors que les languettes de connexion électriques sont encore reliées par des shunts au radiateur de chaleur.
Fig.3 montre en perspective l'élément radiateur et la diode de Fig.2 assemblé au support de Fig.1.
Fig.4 montre en perspective à plus grande échelle, avec parties arrachées, une languette de raccordement électrique séparée mécaniquement des bords de l'échancrure dans laquelle elle est logée.
Fig.5 montre en perspective , à plus petite échelle, une variante de réalisation de Fig.3.
Fig.6 montre, semblablement à Fig.5, une autre variante de réalisation.
Fig.7 est une coupe schématique, à plus grande échelle, suivant la ligne VII - VII de Fig.3 , avec parties en extérieur.
Fig.8 est une coupe schématique, semblable à Fig.7, suivant la ligne VIII - VIII de Fig.3.
Fig. 9, enfin, est une vue en perspective d'un support pour système de signalisation arrière d'un véhicule.

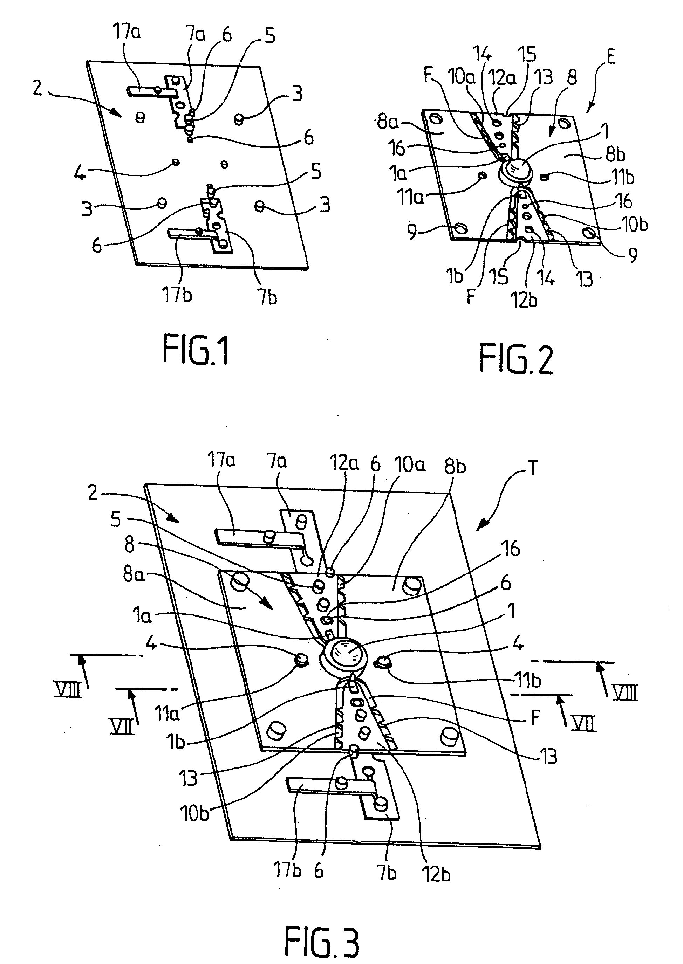

En se reportant à Fig.3 des dessins on peut voir un dispositif support T, ou terminal spécialisé, pour diode électroluminescente de puissance 1, c'est à dire une diode pouvant fournir un flux lumineux d'au moins 30 lumens, et de préférence de 40 lumens ou plus. Dans la suite de la description on utilisera le sigle habituel "led" pour désigner une diode électroluminescente.

La durée de vie d'une led, notamment de puissance, est élevée. Le rendement lumineux d'une led étant élevé également, l'utilisation de leds de puissance pour des systèmes de signalisation ou d'éclairage de véhicule automobile devient particulièrement intéressante.

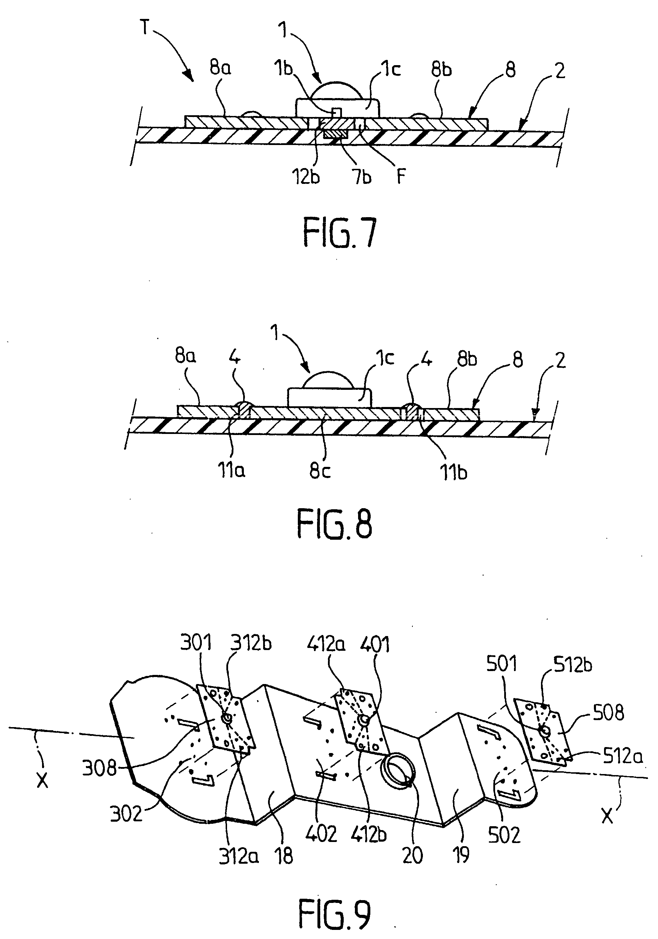

Le dispositif support T comporte un support isolant constitué, dans l'exemple représenté, par une plaque rigide 2 (Fig.1) rectangulaire en matière plastique isolante électriquement. Le support illustré est plan, mais il pourrait présenter une surface courbe, ou étagée comme sur Fig.9. Le support isolant constitue une base en matière plastique correspondant à un dispositif porte-source d'éclairage d'un feu de signalisation.

La plaque 2 comporte des picots, pions ou bouterolles 3, 4, 5 et 6 (Fig.1) en saillie sur sa surface. Les picots 5 forment deux groupes, symétriques relativement au centre de la plaque 2, et alignés suivant la médiatrice des petits côtés de la plaque 2.

Deux pattes d'alimentation électrique 7a, 7b sont logées dans l'épaisseur de la plaque 2 de telle sorte que la surface supérieure des pattes 7a, 7b se trouve à fleur de la surface supérieure de la plaque 2. Les pattes 7a, 7b sont réalisées en un métal bon conducteur de l'électricité, par exemple en cuivre. Les pattes sont écartées l'une de l'autre et, selon Figs.1 et 3, sont alignées suivant la médiatrice des petits côtés de la plaque 2. Les pattes 7a, 7b sont fixées à la plaque 2 par coopération de trous prévus dans les pattes 7a, 7b et de picots 5.

Les picots 3, 4, 5, 6 sont prévus pour positionner et fixer de manière irréversible un sous-ensemble E (Fig.2) formé par un élément radiateur 8 sur lequel la led 1 est fixée.

L'élément radiateur 8 est constitué d'un matériau métallique qui a un coefficient de conduction thermique élevé pour extraire la chaleur émise par la led 1, et qui est également bon conducteur électrique. Ce matériau peut être du cuivre avec une protection étamée ou à base de nickel ou d'alliage au nickel du type NiCr par exemple. Mais on peut aussi utiliser de l'aluminium si le besoin d'extraction de chaleur est moins important, ou des alliages de cuivre assurant une conduction thermique correcte avec une autoprotection vis-à-vis de l'environnement. L'élément radiateur 8 est obtenu de préférence à partir d'une feuille métallique d'épaisseur réduite, en particulier inférieure à 1mm, de faible rigidité. Toutefois l'élément 8 peut être aussi obtenu à partir d'une plaque métallique plus épaisse.

Le corps 1c de la led est en contact, par toute son embase (voir Figs. 7 et 8) avec l'élément radiateur 8. Le corps 1c est fixé sur cet élément 8, par exemple par collage. La transmission de chaleur entre le corps 1a et l'élément 8 s'effectue dans de bonnes conditions, à travers la couche de colle, suivant toute la surface de l'embase du corps 1c.

L'élément 8, selon l'exemple représenté, est rectangulaire et comporte, vers chacun de ses sommets, un trou 9 propre à coopérer avec l'un de quatre picots 3 du support 2 pour la fixation. L'élément 8 a une forme adaptée à celle du support 2.

L'élément radiateur 8 comporte, sur son contour, deux échancrures opposées 10a, 10b, sensiblement en forme de V à pointe arrondie, tournant leur concavité vers l'extérieur et de préférence symétriques par rapport à la médiatrice des côtés non échancrés de l'élément 8. L'élément 8 a sensiblement la forme d'un H dont les deux branches 8a, 8b sont fortement élargies. La led 1 est fixée sur la zone centrale 8c qui assure la liaison entre les branches 8a et 8b. La surface des branches 8a et 8b est importante et la chaleur transmise par l'embase de la led 1 à la zone 8c peut être dissipée efficacement.

Les électrodes, anode et cathode, 1a, 1b de la diode 1 sont placées au droit des échancrures 10a, 10b et ne sont pas en contact avec les branches 8a, 8b.

Le positionnement de l'élément radiateur 8 sur le support 2 est assuré à l'aide d'un trou circulaire 11a prévu dans la branche 8a pour coopérer avec un picot 4 du support 2, et d'un trou oblong 11b dans la branche 8b pour coopérer, en autorisant une tolérance, avec un autre picot 4.

Les moyens de connexion électrique de la led 1 comprennent, dans chaque échancrure 10a, 10b, une languette respective 12a, 12b en matériau conducteur de l'électricité. Lorsque le dispositif est terminé, les bords des languettes 12a, 12b, sont séparés de ceux de l'échancrure correspondante par une fente F continue assurant une isolation électrique. Sur Fig.3, le dispositif support n'est pas totalement achevé, et des attaches ou shunts de liaison 13 subsistent momentanément entre les bords des languettes 12a, 12b et les bords des échancrures.

Les électrodes 1a, 1b de la led sont reliées respectivement à la languette correspondante 12a, 12b par soudure, de préférence par soudure laser. Les languettes comportent des trous 14 prévus pour coopérer avec des picots 5 correspondants du support 2 et assurer la fixation mécanique des languettes sur le support 2. Le bord extérieur de chaque languette 12a, 12b comporte un évidement 15, par exemple semi-circulaire, propre à coopérer avec un picot 6 du support 2 pour assurer le centrage de la languette 12a, 12b. Chaque languette comporte en outre un trou oblong 16 propre à coopérer, en permettant une tolérance, avec un autre picot 6.

L'ensemble est prévu pour que, lors de la mise en place de l'élément radiateur 8 sur le support 2, les zones extérieures des languettes 12a, 12b viennent s'appuyer sur des zones des pattes 7a, 7b situées radialement vers le centre. Un ou plusieurs picots 5 peuvent traverser des trous superposés prévus respectivement dans les pattes 5 et les languettes 12a ou 12b de sorte que la fixation par écrasement de la tête du picot 5 permet d'appliquer efficacement la languette 12a ou 12b contre la patte correspondante 7a, 7b et d'établir ainsi un bon contact électrique. Les pattes 7a, 7b sont prises en sandwich entre le support 2 et les languettes 12a, 12b.

Les zones des pattes 7a, 7b situées à l'extérieur du contour de l'élément radiateur 8 sont reliées à des pattes 17a, 17b qui assurent l'alimentation électrique à partir de conducteurs non représentés.

Les languettes 12a, 12b sont avantageusement découpées dans la même feuille ou plaque métallique que l'élément radiateur 8 de sorte qu'en réalisant les languettes 12a, 12b, on réalise également les échancrures 10a, 10b.

Lors de la fabrication, on effectue tout d'abord une pré-découpe d'une feuille ou plaque de matériau conducteur comme illustré sur les Fig.2 et 3. Selon cette pré-découpe, les languettes 12a, 12b restent attenantes au bord des échancrures 10a, 10b par les shunts 13 de liaison.

Les shunts 13 sont prévus en nombre et en section suffisants pour assurer le maintien mécanique des languettes 12a, 12b et la cohérence du radiateur 8 lors des manipulations et de la fixation sur le support 2. Toutefois, les sections des shunts 13 sont suffisamment réduites pour freiner une diffusion de la chaleur des languettes 12a, 12b vers l'élément radiateur 8 lors du soudage des électrodes 1a, 1b sur les languettes 12a, 12b. Un soudage par laser est avantageux car l'apport de chaleur se fait en un temps réduit, qui permet d'éviter une perte de chaleur par conduction, préjudiciable à la qualité du soudage.

Après avoir pré-découpé le radiateur 8 avec les languettes 12a, 12b et les shunts 13, on effectue le collage de l'embase de la led 1 sur la zone centrale 8c du radiateur. Après collage de la led 1, les électrodes 1a, 1b sont soudées aux languettes 12a, 12b, toujours attenantes mécaniquement à l'élément radiateur 8 par les shunts 13.

Le sous-ensemble E ainsi formé est mis en place et fixé de manière irréversible sur le support 2. Les têtes des différents picots, qui traversent les trous du radiateur 8 et des languettes 12a, 12b, font saillie au-dessus du radiateur et des languettes. Ces têtes sont écrasées par un procédé classique, par exemple par effet thermique simple, par ultrasons ou par échauffement par rayon laser.

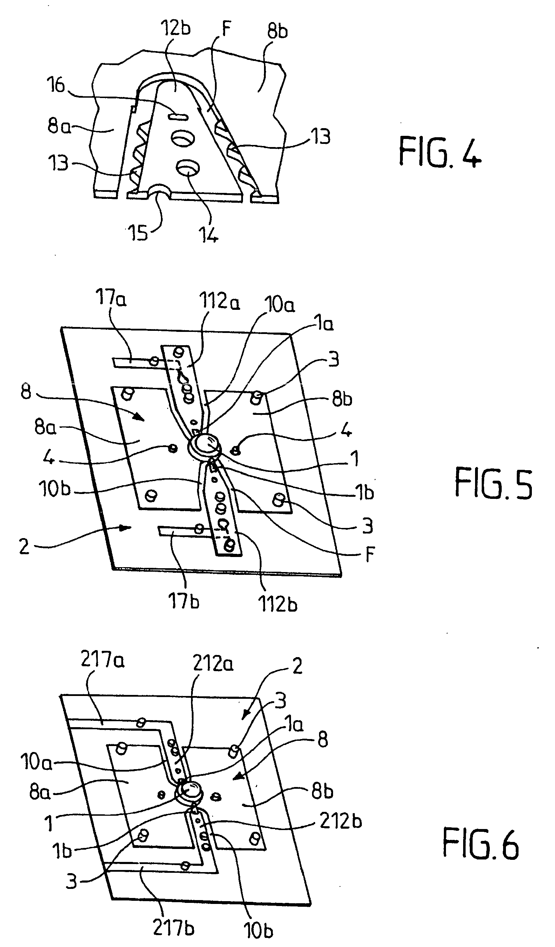

La dernière étape du procédé consiste à rompre mécaniquement les shunts 13 pour assurer la continuité de la fente F et l'isolation électrique des languettes 12a, 12b vis-à-vis du radiateur 8. La rupture des shunts 13, illustrée sur Fig.4, peut être obtenue par tout moyen approprié, par exemple par enfonçage d'un outil. Les pré-entailles issues de l'outil de pré-découpe favorisent cette opération.

Le dispositif support de led de puissance ainsi obtenu est économique et utilise un support 2 qui peut convenir aussi bien à une led de puissance qu' à une lampe classique.

Fig.5 montre une variante de réalisation selon laquelle les languettes conductrices 112a, 112b, logées dans les échancrures 10a, 10b font saillie, suivant la direction moyenne des échancrures, au-delà du contour extérieur de l'élément radiateur 8. Ceci permet d'établir une connexion électrique directe avec les pattes 17a, 17b, et de supprimer les pattes d'alimentation 7a, 7b prévues sur les Fig. 1 et 3. Les pattes 17a, 17b, sont de préférence logées dans l'épaisseur de la plaque 2 de telle sorte que la surface supérieure des pattes 17a, 17b se trouve à fleur de la surface supérieure de la plaque 2. Les languettes 112a, 112b recouvrent une partie des pattes 17a, 17b pour établir le contact.

Les languettes 112a, 112b peuvent être découpées dans la même feuille de métal conducteur que l'élément radiateur 8. Les zones des languettes 112a, 112b situées dans les échancrures 10a, 10b sont simplement pré-découpées initialement comme sur Fig.2 et 3 et restent attenantes au bord des échancrures 10a, 10b par des shunts semblables à 13. Après soudure des électrodes de la led 1 sur les languettes 112a, 112b et après fixation du radiateur 8 et des languettes sur le support 2, les shunts de liaison sont rompus comme illustré sur Fig.4.

Cette variante permet de sécuriser la qualité de la connectique obtenue. La gamme de montage est en outre simplifiée.

Fig.6 montre une autre variante de réalisation selon laquelle les languettes conductrices 212a, 212b logées dans les échancrures 10a, 10b sont d'une seule pièce avec les pattes d'alimentation respectives 217a, 217b. Chaque languette 212a, 212b, avec la patte correspondante 217a, 217b forme une équerre fixée sur le support 2. Une branche de l'équerre, formant la languette 212a, 212b, est engagée dans l'échancrure 10a, 10b sur une distance suffisante pour permettre de souder une électrode de la led 1 à l'extrémité de cette languette. Les languettes font saillie hors des échancrures 10a, 10b pour que les pattes 217a, 217b soient suffisamment distantes du contour de l'élément radiateur 8.

Cette variante demande une optimisation dans le choix du matériau utilisé pour réaliser l'ensemble d'une languette 212a, 212b et d'une patte 217a, 217b. La gamme de montage est encore simplifiée par rapport à la solution de Fig.5.

Fig. 9 montre en perspective un exemple de réalisation selon l'invention pour une signalisation arrière de véhicule.

Le support isolant d'une seule pièce en matière plastique comporte trois plaques 302, 402, 502, situées dans des plans parallèles décalés, et reliées par des parois inclinées 18, 19 sensiblement orthogonales aux plaques . La direction moyenne X - X du support, quand il est installé sur le véhicule, est horizontale, perpendiculaire à l'axe longitudinal du véhicule; les plaques 302, 402, 502 se trouvent dans des plans verticaux, perpendiculaires à l'axe longitudinal du véhicule. La dimension du support suivant une direction orthogonale à l'axe X - X augmente progressivement de la plaque 502, située vers l'extérieur du véhicule, à la plaque 302 plus proche de l'axe longitudinal du véhicule.

Chaque plaque 302, 402, 502 est équipée de pions semblables aux pions 3, 4, 5, 6 des Figs. 1 et 3, et de pattes d'alimentation électrique semblables aux pattes 17a, 17b, des Figs. 1 et 3, pour recevoir respectivement un élément radiateur 308, 408, 508 sur lequel est installée une led 301, 401, 501. Des échancrures avec languettes prédécoupées 312a, 312b, 412a, 412b, 512a, 512b, sont prévues dans chaque élément radiateur. Les languettes d'un même élément radiateur ont leurs lignes moyennes orientées suivant deux demi-diagonales successives et font saillie dans un angle du contour extérieur de l'élément radiateur pour venir au contact d'une patte de la plaque correspondante. Chaque sous-ensemble formé par un élément radiateur, une led et les languettes est semblable à celui de Fig.2 , et sa fixation sur la plaque correspondante du support s'effectue comme décrit précédemment. Les shunts de liaison des languettes avec l'élément radiateur sont rompus après fixation de l'élément 308, 408, 508 sur le support isolant.

Les leds de puissance 301, 401, 301, assurent respectivement une fonction différente, par exemple feu de stop, lanterne, clignotant, et sont commandées en conséquence.

La plaque intermédiaire 402, plus étendue que les deux autres suivant la direction X-X, comporte au voisinage de la paroi 19 un trou 20 pour la mise en place d'une source lumineuse classique pour feu de recul.

Quelle que soit la variante de réalisation, l'invention permet d'avoir un choix de matériau au niveau du radiateur portant la led, et de réaliser la liaison mécanique et électrique en favorisant les échanges thermiques.

## Revendications

1. Dispositif support de diode électroluminescente de puissance pour système de signalisation ou d'éclairage automobile, comportant un support isolant, notamment en matière plastique, et des moyens de connexion électrique aux électrodes de la diode, où les moyens de connexion électrique comprennent, sur le support isolant (2), des pattes de raccordement électrique (17a, 17b; 217a, 217b) ; le corps (1c) de la diode électroluminescente (1) est fixé sur une zone (8c) d'un élément radiateur de chaleur (8; 308, 408, 508); cet élément radiateur de chaleur est rapporté sur le support isolant (2; 302, 402, 502), et les électrodes (1a, 1b) de la diode sont isolées de l'élément radiateur de chaleur et reliées électriquement aux pattes de raccordement (17a, 17b; 217a, 217b) du support isolant, **caractérisé en ce que** l'élément radiateur de chaleur (8; 308, 408, 508) comporte, sur son contour, au moins une échancrure (10a, 10b) en direction de la zone de fixation de la diode électroluminescente, au moins l'une des électrodes (1a, 1b) de la diode étant disposée dans une échancrure correspondante (10a, 10b) de l'élément radiateur.

2. Dispositif selon la revendication 1, **caractérisé en ce que** les moyens de connexion électrique comprennent dans l'échancrure ou dans chaque échancrure une languette (12a, 12b;112a, 112b; 212a, 212b; 312a - 512b) en matériau conducteur de l'électricité dont les bords sont distants de ceux l'échancrure et dont l'extrémité radiale extérieure se trouve au voisinage ou au-delà du contour extérieur de l'élément radiateur.

3. Dispositif selon la revendication 1 ou 2, **caractérisé en ce que** la diode électroluminescente de puissance peut produire un flux lumineux d'au moins 30 lumens.

4. Dispositif selon l'une des revendications 1 à 3, **caractérisé en ce que** la zone de fixation (8c) de l'embase de la diode électroluminescente (1) est constituée par la zone centrale de l'élément radiateur (8), lequel comportent deux échancrures opposées (10a, 10b) partant de son contour et dirigées vers la zone centrale, chaque électrode (1a, 1b) de la diode étant située respectivement dans une échancrure, et une languette conductrice électriquement (12a,12b;112a,112b;212a,212b) se trouvant dans chaque échancrure et étant reliée à l'électrode correspondante, les bords de la languette étant distants de ceux de l'échancrure.

5. Dispositif selon l'une des revendication 2, 4 et 3 lorsqu'elle depend de la revendication 2 **caractérisé en ce que** la languette (12a, 12b;112a, 112b) est constituée par une partie découpée de la feuille ou plaque formant radiateur, en correspondance avec une échancrure (10a, 10b).

6. Dispositif selon l'une des revendications, 2, 4 et 3 lorsqu'elle depend de la revendication 2 **caractérisé en ce que** le bord de la languette (112a, 112b) éloigné de la diode électroluminescente (1) fait saillie au-delà du contour de l'élément radiateur (8)

7. Dispositif selon l'une des revendications précédentes, **caractérisé en ce que** l'assemblage de l'élément radiateur (8; 308, 408, 508) et du support isolant (2; 302, 402, 502) est assuré par coopération de trous (9, 11a, 11b. 14, 16) prévus dans l'élément radiateur et de picots ou pions (3, 4, 5, 6) prévus sur le support isolant.

8. Dispositif selon l'une des revendications précédentes, **caractérisé en ce que** les électrodes (1a, 1b) de la diode sont soudées par point, en particulier au laser.

9. Dispositif selon l'une des revendications précédentes, **caractérisé en ce que** le support isolant d'une seule pièce comporte plusieurs plaques (302,402,502) situées dans des plans parallèles décalés, et reliées par des parois inclinées (18,19), chaque plaque étant équipée d'une diode de puissance (301,401,501) assurant une fonction déterminée.

10. Procédé de fabrication d'un dispositif support selon l'une des revendications précédentes, **caractérisé en ce que** l'on prépare séparément un support isolant (2; 302,402, 502), notamment en matière plastique, muni de pattes de raccordement électrique (7a, 17a,217a ; 7b, 17b,217b), et un ensemble radiateur (8; 308, 408, 508) comportant une diode électroluminescente de puissance, et que l'on assemble mécaniquement le radiateur et le support isolant en assurant la liaison électrique des électrodes (1a, 1b) de la diode avec les pattes de raccordement.

11. Procédé selon la revendication 10, **caractérisé en ce qu'**on réalise l'ensemble radiateur (8; 308, 408, 508) à partir d'une feuille ou d'une plaque de métal conducteur de la chaleur et de l'électricité, notamment du cuivre, dans laquelle on découpe partiellement, de part et d'autre d'une zone centrale (8c), des languettes (12a, 12b; 112a, 112b) qui restent momentanément reliées par des attaches (13) de section réduite, formant shunts, à la majeure partie (8a, 8b) de la feuille ou plaque pour assurer sa cohérence et son maintien mécanique; on met en place et on fixe, en particulier par collage, la diode électroluminescente (1) sur la zone centrale (8c) de l'élément radiateur; on procède à la soudure de chaque électrode (1a, 1b) de la diode avec une languette respective et on brise ensuite les shunts de liaison (13) entre languettes et élément radiateur de manière à assurer l'isolation électrique de chaque languette vis-à-vis de l'élément radiateur.

12. Procédé selon la revendication 11, **caractérisé en ce que** les shunts de liaison (13) entre une languette (12a, 12b) et l'élément radiateur (8) ont une section suffisante pour assurer le maintien mécanique, mais relativement faible pour limiter l'évacuation de chaleur par les shunts lors de la soudure des électrodes sur les languettes.

13. Système de signalisation ou d'éclairage automobile comportant le dispositif support selon l'une des revendications 1 à 9.

## Patentansprüche

1. Trägervorrichtung für Hochleistungs-Leuchtdiode für Signalgebungs- oder Beleuchtungssysteme für Kraftfahrzeuge, mit einem nicht leitenden Träger insbesondere aus Kunststoff und Mitteln zum elektrischen Anschluss an die Elektroden der Diode, bei der die elektrischen Anschlussmittel auf dem nicht leitenden Träger (2) Anschlussklammern (17a, 17b; 217a, 217b) aufweisen, das Gehäuse (1c) der Leuchtdiode (1) auf einem Bereich (8c) eines Kühlkörpers (8; 308, 408, 508) befestigt ist, dieser Kühlkörper auf den nicht leitenden Träger (2; 302, 402, 502) aufgesetzt ist, und die Elektroden (1a, 1b) der Diode von dem Kühlkörper getrennt und elektrisch mit den Anschlussklammern (17a, 17b; 217a, 217b) des nicht leitenden Trägers verbunden sind,
**dadurch gekennzeichnet, dass** der Kühlkörper (8; 308, 408, 508) an seinem Rand wenigstens einen Ausschnitt (10a, 10b) in Richtung des Befestigungsbereiches der Leuchtdiode aufweist, wobei wenigstens eine der Elektroden (1a, 1b) der Diode in einem entsprechenden Ausschnitt (10a, 10b) des Kühlkörpers angeordnet ist.

2. Vorrichtung nach Anspruch 1,
**dadurch gekennzeichnet, dass** die elektrischen Anschlussmittel in dem Ausschnitt oder in jedem Ausschnitt eine Zunge (12a, 12b; 112a, 112b; 212a, 212b; 312a - 512b) aus elektrisch leitfähigem Material aufweisen, deren Ränder von denen des Ausschnitts beabstandet sind und deren äußeres radiales Ende sich in der Nähe oder jenseits des äußeren Randes des Kühlkörpers befindet.

3. Vorrichtung nach Anspruch 1 oder 2,
**dadurch gekennzeichnet, dass** die Hochleistungs-Leuchtdiode einen Lichtstrom von mindestens 30 Lumen erzeugen kann.

4. Vorrichtung nach einem der Ansprüche 1 bis 3,
**dadurch gekennzeichnet, dass** der Befestigungsbereich (8c) des Sockels der Leuchtdiode (1) durch den mittleren Bereich des Kühlkörpers (8) gebildet ist, der zwei gegenüberliegende Ausschnitte (10a, 10b) aufweist, die von seinem Rand ausgehen und zu dem mittleren Bereich gerichtet sind, wobei jede Elektrode (1a, 1b) der Diode jeweils in einem Ausschnitt angeordnet ist und sich eine leitfähige Zunge (12a, 12b; 112a, 112b; 212a, 212b) in jedem Ausschnitt befindet und mit der entsprechenden Elektrode verbunden ist, wobei die Ränder der Zunge von denen des Ausschnitts beabstandet sind.

5. Vorrichtung nach einem der Ansprüche 2, 4 oder 3, wenn dieser von Anspruch 2 abhängt,
**dadurch gekennzeichnet, dass** die Zunge (12a, 12b; 112a, 112b) durch einen Teil gebildet ist, der entsprechend einem Ausschnitt (10a, 10b) aus der den Kühlkörper bildenden Folie oder Platte ausgeschnitten ist.

6. Vorrichtung nach einem der vorhergehenden Ansprüche 2, 4 oder 3, wenn dieser von Anspruch 2 abhängt,
**dadurch gekennzeichnet, dass** der von der Leuchtdiode (1) entfernte Rand der Zunge (112a, 112b) über den Rand des Kühlkörpers (8) hinausragt.

7. Vorrichtung nach einem der vorhergehenden Ansprüche,
**dadurch gekennzeichnet, dass** die Verbindung zwischen dem Kühlkörper (8; 308, 408, 508) und dem nicht leitenden Träger (2; 302, 402, 502) durch das Zusammenwirken von Löchern (9, 11a, 11b, 14, 16), die in dem Kühlkörper vorgesehen sind, und Pins oder Stiften (3, 4, 5, 6), die auf dem nicht leitenden Träger vorgesehen sind, gewährleistet ist.

8. Vorrichtung nach einem der vorhergehenden Ansprüche,
**dadurch gekennzeichnet, dass** die Elektroden (1a, 1b) der Diode insbesondere mit Laser punktgeschweißt sind.

9. Vorrichtung nach einem der vorhergehenden Ansprüche,
**dadurch gekennzeichnet, dass** der nicht leitende, einstückige Träger mehrere Platten (302, 402, 502) umfasst, die in zueinander versetzten, parallelen Ebenen angeordnet und durch schräge Wände (18, 19) miteinander verbunden sind, wobei jede Platte mit einer Hochleistungs-Diode (301, 401, 501) versehen ist, die eine bestimmte Funktion erfüllt.

10. Verfahren zur Herstellung einer Trägervorrichtung nach einem der vorhergehenden Ansprüche,
**dadurch gekennzeichnet, dass** ein nicht leitender Träger (2; 302, 402, 502) insbesondere aus Kunststoff, der mit Anschlussklammern (7a, 17a, 217a; 7b, 17b, 217b) versehen ist, und eine Kühlkörpereinheit (8; 308, 408, 508), die eine Hochleistungs-Leuchtdiode umfasst, getrennt voneinander hergestellt werden, und dass der Kühlkörper und der nicht leitende Träger mechanisch miteinander verbunden werden, indem die elektrische Verbindung zwischen den Elektroden (1a, 1b) der Diode und den Anschlussklammern hergestellt wird.

11. Verfahren nach Anspruch 10,
**dadurch gekennzeichnet, dass** die Kühlkörpereinheit (8; 308, 408, 508) ausgehend von einer Wärme und Strom leitenden Metallfolie oder -platte insbesondere aus Kupfer hergestellt wird, in der zu beiden Seiten eines mittleren Bereichs (8c) Zungen (12a, 12b; 112a, 112b) ausgeschnitten sind, die vorübergehend mit dem Hauptteil (8a, 8b) der Folie oder der Platte durch Brücken bildende Verbindungsstücke (13) mit sich verjüngendem Querschnitt verbunden bleiben, um deren Zusammenhalt und mechanischen Halt zu gewährleisten, die Leuchtdiode (1) auf dem mittleren Bereich (8c) des Kühlkörpers aufgebracht und insbesondere durch Kleben befestigt wird, jede Elektrode (1a, 1b) der Diode mit einer entsprechenden Zunge verschweißt wird, und die Verbindungsbrücken (13) zwischen den Zungen und dem Kühlkörper durch Brechen getrennt werden, so dass die elektrische Isolierung einer jeden Zunge gegenüber dem Kühlkörper gewährleistet ist.

12. Verfahren nach Anspruch 11,
**dadurch gekennzeichnet, dass** die Verbindungsbrücken (13) zwischen einer Zunge (12a, 12b) und dem Kühlkörper (8) einen Querschnitt haben, der ausreicht, um den mechanischen Halt zu gewährleisten, aber so gering ist, dass die Wärmeableitung über die Brücken beim Verschweißen der Elektroden auf den Zungen begrenzt ist.

13. Signalgebungs- und Beleuchtungssystem für Kraftfahrzeuge mit der Trägervorrichtung nach einem der Ansprüche 1 bis 9.

## Claims

1. A support device for a light emitting power diode for an automotive signalling or lighting system, the device comprising an insulating support member, in particular made of plastics material, and means for electrically connecting it to the electrodes of the diode, the electrical connecting means comprising, on the insulating support member(2), electrical connecting tags (17a, 17b; 217a, 217b); the body (1c) of the light emitting diode is fixed on a zone (8c) of a heat radiator element (8; 308, 408, 508); the said heat radiator element is attached on the insulating support member (2; 302, 402, 502), and the electrodes of the diode are insulated from the heat radiator element and connected electrically to the connecting tags (17a, 17b; 217a, 217b) of the insulating support member,
**characterised in that** the heat radiator element (8; 308, 408, 508) has, on its contour, at least one depression (10a, 10b) directed towards the zone of fastening of the light emitting diode, at least one of the electrodes (1a,1b) of the diode being disposed in a corresponding depression (10a, 10b) of the radiator element.

2. A device according to Claim 1, **characterised in that** the electrical connection means comprise, in the depression or in each depression, a tongue (12a, 12b; 112a, 112b; 212a, 212b; 312a-512b) of an electrically conductive material, the edges of which are remote from the said depression or depressions, and the outer radial end of which is in the vicinity of, or beyond, the outer contour of the radiator element.

3. A device according to Claim 1 or Claim 2, **characterised in that** the light emitting power diode is capable of producing a light flux of at least 30 lumen.

4. A device according to any one of Claims 1 to 3, **characterised in that** the fastening zone (8c) for the base of the light emitting diode (1) is defined by the central zone of the radiator (8), which includes two opposed depressions (10a, 10b) extending from its contour and towards the central zone, each electrode (1a, 1b) of the diode being situated in a respective depression, and an electrically conductive tongue (12a, 12b; 112a, 112b; 212a, 212b) being located in each depression and connected to the corresponding electrode, the edges of the tongue being remote from those of the depression.

5. A device according to Claim 2, Claim 4 or Claim 3 when dependent on Claim 2, **characterised in that** the tongue (112a, 112b) spaced away from the light emitting diode (1) is defined by a cut-out portion of the leaf or plate element constituting the radiator, in corresponding relationship with the radiator element (8).

6. A device according to Claim 2, Claim 4 or Claim 3 when dependent on Claim 2, **characterised in that** the edge of the tongue (112a, 112b) spaced away from the light emitting diode (1) projects from the contour of the radiator element (8).

7. A device according to one of the preceding Claims, **characterised in that** the radiator element (8; 308, 408, 508) and insulating support member (2; 302, 402, 502) are assembled together by cooperation of holes (9, 11a, 11b, 14, 16) which are formed in the radiator element, with pegs or pins (3, 4, 5, 6) arranged on the insulating support member.

8. A device according to one of the preceding Claims, **characterised in that** the electrodes (1a, 1b) are spot welded, in particular to the laser.

9. A device according to one of the preceding Claims, **characterised in that** the insulating support member is in one piece and includes a plurality of plate portions (302, 402, 502) situated in planes which are offset from each other and joined together by inclined walls (18, 19), each plate portion being equipped with a power diode (301, 401, 501) having a predetermined function.

10. A method of making a support device according to one of the preceding Claims, **characterised in that** it comprises preparing, separately, an insulating support member (2; 302, 402, 502), in particular in plastics material, having electrical connecting tags (7a, 17a, 217a; 7b, 117b, 217b), and a radiator assembly (8; 308, 408, 508) including a light emitting power diode, and **in that** the radiator and the insulating support member are assembled mechanically together by making the electrical connection between the electrodes (1a, 1b) of the diode and the connecting tags.

11. A method according to Claim 10, **characterised in that** the radiator assembly (308, 408, 508) is made from a leaf or plate element which is a conductor of heat and electricity, being in particular of copper, the method including partially cutting out, on either side of a central zone (8c), tongues (12a, 12b; 112a, 112b) which remain for the moment attached, by means of attachment elements (13) of reduced thickness constituting shunts, to the major part (8a, 8b) of the leaf or plate element, whereby to ensure its cohesion and mechanical retention; putting the light emitting diode (1) in place and fixing it, in particular by adhesive bonding, on the central zone (8c) of the radiator element; welding each electrode (1a, 1b) of the diode to a respective tongue, and then breaking the connecting shunts (13) between tongues and radiator element, whereby to ensure that each tongue is insulated electrically from the radiator element.

12. A method according to Claim 11, **characterised in that** the connecting shunts (13) between a tongue (12a, 12b) and the radiator element (8) have a cross section large enough to ensure mechanical retention, but relatively weak in order to limit the evacuation of heat by the shunts during welding of the electrodes on the tongues.

13. An automotive signalling or lighting system including the support device according to one of Claims 1 to 9.
